Europäisches Patentamt

European Patent Office

Office européen des brevets

(19)

(11) Veröffentlichungsnummer : **0 017 676**
**B1**

(12) **EUROPÄISCHE PATENTSCHRIFT**

(45) Veröffentlichungstag der Patentschrift :
26.01.83

(21) Anmeldenummer : 79200189.3

(22) Anmeldetag : 17.04.79

(51) Int. Cl.³ : **G 01 R 27/16**, G 01 R 27/26,
G 01 R 25/00, G 05 F 1/12,
G 06 G 7/19,
G 06 G 7/635// H02H7/26

(54) **Verfahren zur Bestimmung einer Längs-Ersatzreaktanz in einem elektrischen Netz.**

(30) Priorität : 23.03.79 CH 2735/79

(43) Veröffentlichungstag der Anmeldung :
29.10.80 Patentblatt 80/22

(45) Bekanntmachung des Hinweises auf die Patenterteilung : 26.01.83 Patentblatt 83/04

(84) Benannte Vertragsstaaten :
CH DE FR

(56) Entgegenhaltungen :
DE B 1 516 084
DE B 2 247 746
US A 3 526 761

(73) Patentinhaber : BBC Aktiengesellschaft Brown,
Boveri & Cie.
Haselstrasse
CH-5401 Baden (CH)

(72) Erfinder : Bonanomi, Peter, Dipl.-Ing.
Niederdorfstrasse 58
CH-8001 Zürich (CH)

## Verfahren zur Bestimmung einer Längs-Ersatzreaktanz in einem elektrischen Netz

Die Erfindung bezieht sich auf ein Verfahren zur Bestimmung einer Längs-Ersatzreaktanz in einem elektrischen Netz zwischen einem Meßort und einem Ort amplituden- und phasenstarrer Netzspannung, insbesondere am Anschlussort eines Generators an ein Leitungsnetz.

Bei der Führung und Regelung von elektrischen Hochleistungsnetzen, insbesondere auch bei der Regelung der im Netz enthaltenen Generatoren, werden gewisse Reaktanzwerte des Netzes als Parametergrössen oder -signale benötigt. Hierzu gehört die Längs-Ersatzreaktanz bezüglich eines Messortes, d.h. die Längsreaktanz zwischen der Netzspannung am Messort einerseits und einer als amplituden- und phasenstarr anzunehmenden Netzspannung, welche also den mit dem betreffenden Messort bzw. mit dem hier angeschlossenen Generator gekoppelten Netzabschnitt begrenzt. Es handelt sich dabei im wesentlichen um die Innenreaktanz einer den genannten Netzabschnitt repräsentierenden Ersatzquelle mit der erwähnten, starren Netzspannung als eingeprägter Quellenspannung. Da es sich um eine Längsreaktanz handelt, können die Resistanzen und Kapazitanzen gegenüber den Induktanzen im allgemeinen vernachlässigt werden, was zu der alleinigen Behandlung einer Ersatzreaktanz berechtigt.

Der Wert der Längs-Ersatzreaktanz eines Netzes bezüglich eines Messortes kann grundsätzlich aus der gesamten Netzkonfiguration unter Berücksichtigung der jeweiligen Lastzustände ermittelt werden. Für den praktischen Betrieb ist eine solche Ermittlung jedoch nicht anwendbar, weil der Lastzustand und auch die Netzkonfiguration mehr oder weniger starken, laufenden Aenderungen unterliegen, weshalb eine Erfassung ein umfangreiches Mess- und Datenübermittlungssystem zur Voraussetzung hätte. Aufgabe der Erfindung ist daher die Schaffung eines Verfahrens zur Bestimmung der Längs-Ersatzreaktanz bezüglich eines Messortes ausschliesslich unter Zuhilfenahme von hier verfügbaren Messgrössen, wobei der Aufwand grundsätzlich in einem solchen Rahmen zu halten ist, dass eine wiederholte oder laufende Reaktanzbestimmung für Zwecke der Netzführung und Generatorregelung möglich ist. Die erfindungsgemässe Lösung dieser Aufgabe kennzeichnet sich durch die im Anspruch 1 angegebenen Merkmale.

Der Grundgedanke des erfindungsgemässen Verfahrens besteht darin, für eine Mehrzahl von vorgegebenen Werten der gesuchten Längs-Ersatzreaktanz unter Verwendung von ausschliesslich am Messort gewonnenen Messgrössen, nämlich Netzspannung, Wirk- und Blindleistung, die zugehörigen Werte der Netzspannungs-Phasenwinkeldifferenz beiderseits dieser Reaktanz zu bestimmen und mit einem unmittelbar aus den genannten Messgrössen bestimmten Phasenwinkel der lokalen Netzspannung gegenüber einer lokalen Referenz zu vergleichen. Die relativ beste Uebereinstimmung zwischen einem der mit einem Ersatzreaktanzwert berechneten Phasenwinkeldifferenz und dem lokalen Netzspannungs-Phasenwinkel wird sodann als Kriterium für die Auswahl des zugehörigen, vorgegebenen Reaktanzwertes als Näherungsergebnis verwendet. Die genannte Phasenwinkeldifferenz beiderseit der Längsreaktanz ist nämlich nichts anderes als der Phasenwinkel der lokalen Netzspannung gegenüber der starren Ersatzquellenspannung.

Die Erfindung wird weiter anhand der in den Zeichnungen veranschaulichten Ausführungsbeispiele erläutert. Hierin zeigt :

Figur 1 das Blockbild einer Schaltungsanordnung zur Ersatzreaktanzbestimmung nach dem erfindungsgemässen Verfahren,

Figur 2 ein Phasenwinkel-Zeitdiagramm zur Erläuterung der Verfahrensweise und

Figuren 3a und 3b Zeitablaufdiagramme zur Durchführung des erfindungsgemässen Verfahrens in allgemeiner Form.

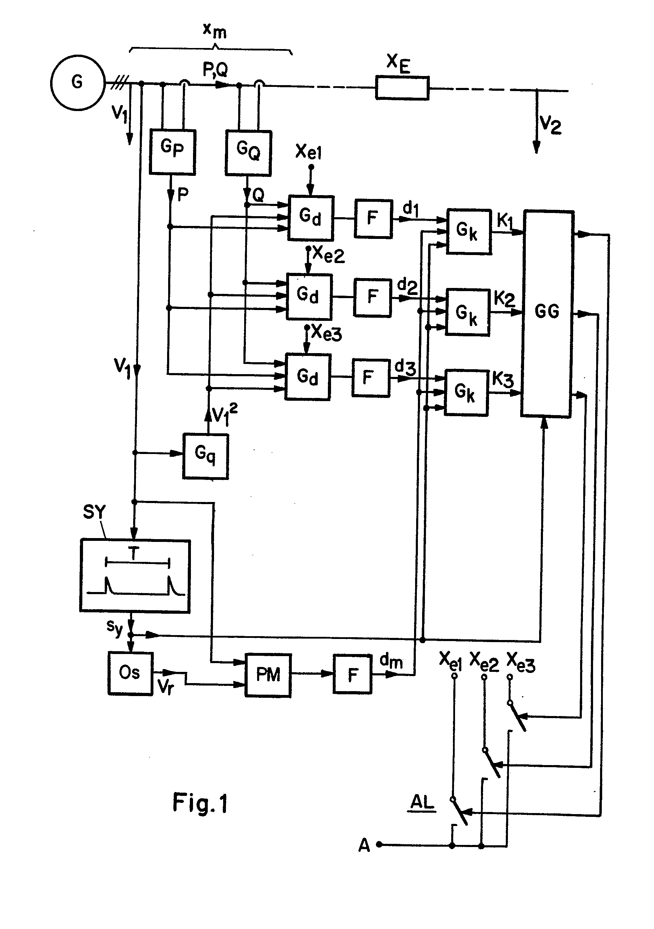

Nach Fig. 1 werden an einem Messort $x_m$, beispielsweise dem Anschlussort eines Generators G, die lokale Netzspannung $V_1$ sowie die Wirkleistung P und die Blindleistung Q in entsprechenden Messeinrichtungen $G_P$ und $G_Q$ erfasst. Der mit dem Messort bzw. dem Generator gekoppelte Netzabschnitt ist gemäss vorstehenden Erläuterungen durch eine Ersatzquelle mit der Längs- oder Innenreaktanz $X_E$ und mit der starren Quellenspannung $V_2$ repräsentiert. Die Wirkleistung P wird durch diese starre Quelle aufgenommen oder abgegeben.

Aus P und Q sowie dem in einem Funktionsgeber $G_q$ gebildeten Quadrat $V_1 2$ der lokalen Netzspannung werden sodann in einer Mehrzahl von Funktionsgebern $G_d$ mit je einem von aussen zugeführten, vorgegebenen Ersatzreaktanzwert $X_{e1}$ bis $X_{e3}$ entsprechende Zeitverläufe einer Netzspannungs-Phasenwinkeldifferenz $d_1$ bis $d_3$ gebildet. Diese Funktionsgeber arbeiten nach der an sich allgemein bekannten Beziehung

$$d_1 \ldots = \arctan \frac{P}{\dfrac{V_1 2}{X_{e1} \ldots} - Q} \qquad (1)$$

Für die Verwirklichung einer solchen Funktion können allgemein übliche und daher hier nicht näher zu erläuternde Analogoder Digitalschaltungen verwendet werden, die grundsätzlich kommerziell erhältlich sind.

Ferner wird die lokale Netzspannung $V_1$ zusammen mit einer wenigstens annähernd starren Referenzspannung $V_r$ aus einem lokalen Oszillator Os einem Phasenwinkel-Messgerät PM zugeführt und damit der lokale Netzspannungs-Phasenwinkel $d_m$ in Form einer Messgrösse gebildet. Die Signale bzw. Messgrössen $d_1$ bis $d_3$ und $d_m$ sind über Filter F geführt, die zeitlich lineare Komponenten der betreffenden Signale unterdrücken, d.h. Gleich- und Rampenkomponenten, die für die übliche dynamische Führung und Regelung uninteressant sind und die nachfolgende Aehnlichkeitsprüfung erschweren würden. Geeignete, an sich übliche Filterschaltungen mit Differential- und Integralkomponente ihrer Uebertragungsfunktion können hier grundsätzlich verwendet werden.

Anschliessend wird der Verlauf je einer Phasenwinkeldifferenz $d_1$ bis $d_3$ in Bezug auf den Verlauf des lokalen Phasenwinkels $d_m$ in einer Korrelationsschaltung $G_k$ einer Aehnlichkeitsprüfung unterzogen. Es handelt sich hierbei um grundsätzlich übliche Korrelationsschaltungen, beispielsweise um integrierende Kreuzkorrelatoren, die je ein Korrelat $K_1$ bis $K_3$ als Aehnlichkeits-Kenngrösse liefern. Im Beispielsfall ist angenommen, dass die Integration dieser Korrelatoren und damit die Aehnlichkeitsprüfung über definierte Zeitintervalle entsprechend jeweils einem bestimmten Verlaufsabschnitt der zugeführten Signale erfolgt. Dazu ist ein Synchron-Impulsgeber SY vorgesehen, der jeweils nach einem Zeitintervall T ein Synchronisier- bzw. Rückstellsignal $s_y$ an die Korrelatoren gibt. Dieses Signal sorgt auch für eine periodische Synchronisierung des Oszillators Us mit der lokalen Netzspannung zur Korrektur etwaiger Drifterscheinungen. Ausserdem bewirkt dieses Signal jeweils kurz vor der Rückstellung der Korrelator-Integratoren die Ausgabe der Korrelate $K_1$ bis $K_3$ an eine Grenzwert-Auswahlschaltung GG. Im Falle einer einfachen Kreuzkorrelation, wobei das Korrelat ein gleichsinniges Mass für die Aehnlichkeit der Verlaufsabschnitte darstellt, ist hier eine Maximalwert-Auswahlschaltung, bei inverser Zuordnung, die ebenfalls grundsätzlich anwendbar ist, eine Minimalwert-Auswahlschaltung zu verwenden. Die Grenzwert-Auswahlschaltung GG weist den Korrelaten $K_1$ bis $K_3$ zugeordnete, nicht näher bezeichnete Ausgänge auf, wobei jeweils nur derjenige Ausgang ein bejahendes Binärsignal führt, welcher dem jeweils grössten Korrelat bzw. derjenigen Phasenwinkeldifferenz $d_1$ bis $d_3$ zugeordnet ist, welche in ihrem Verlauf die grösste Aehnlichkeit mit demjenigen des lokalen Phasenwinkels $d_m$ aufweist. Der zugehörige, vorgegebene Ersatzreaktanzwert $X_{e1}$ bis $X_{e3}$ wird dann über eine Ausgabelogik AL als Ergebnis zum Ausgang A durchgeschaltet.

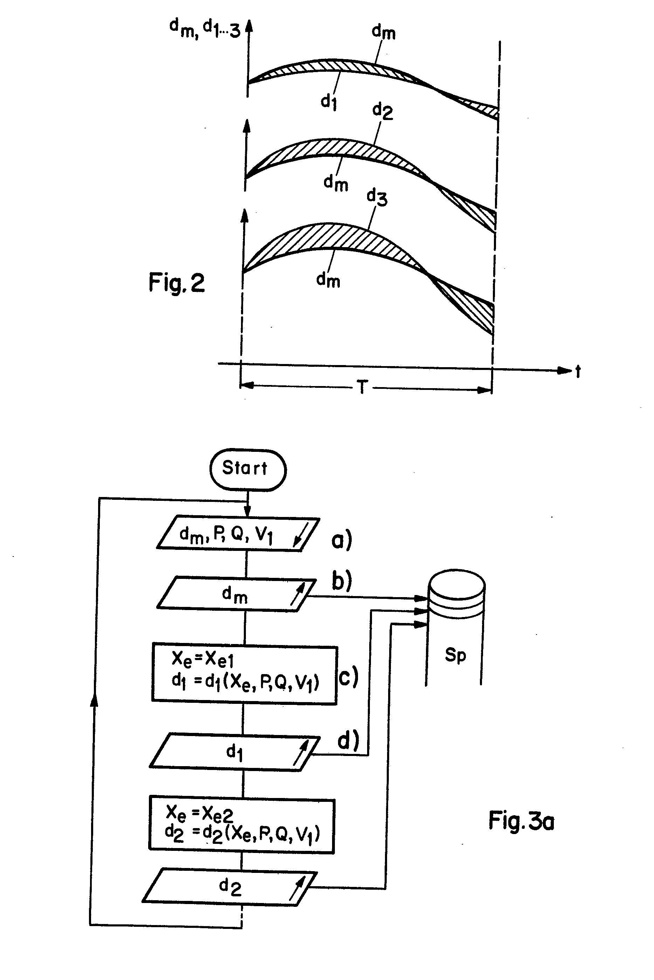

Fig. 2 zeigt über der Zeit t drei beispielsweise angegebene Verläufe der Phasenwinkeldifferenzen $d_1$ bis $d_3$ für entsprechend unterschiedliche, vorgegebene Werte der Ersatzreaktanz $X_{e1}$ bis $X_{e3}$. Diese Werte werden in der Praxis nach Plausibilitätserwägungen unter Berücksichtigung der bekannten Grob- Netzverhältnisse so gewählt, dass der wirkliche Reaktanzwert im Variationsbereich der vorgegebenen Werte liegt. Die Aehnlichkeitsprüfung des Verlaufs, jeweils über ein Zeitintervall T, kann beispielsweise wie in Fig. 2 veranschaulicht durch Differenzbildung zwischen $d_m$ und $d_1$ bis $d_3$

(siehe die schraffierten Differenzflächen) mit Korrelation des Differenzwertes mit einer der differenzbildenden Grössen, beispielsweise $d_m$, durchgeführt werden. In diesem Fall ergibt sich ein inverses Aehnlichkeitskriterium mit entsprechender Minimalwertauswahl. Die Korrelation selbst kann in üblicher Weise durch Multiplikation — im Beispielsfall also des Differenzwertes — mit einer der differenzbildenden Grössen und Integration über das Intervall T durchgeführt werden.

Fig. 3a zeigt einen ersten, zyklisch ablaufenden Abschnitt des Verfahrens. Danach wird im Anschluss an den Verfahrensstart jeweils ein Satz von Messgrössen $d_m$, P, Q, $V_1$ im Verfahrensschritt a) aufgenommen und anschliessend im Verfahrensschritt b) die Grösse $d_m$ in einen Speicher Sp ausgegeben. Anschliessend wird unter Verwendung der Messgrössen P, Q, $V_1$ und des vorgegebenen Reaktanzwertes $X_{e1}$ die Grösse $d_1$ der Phasenwinkeldifferenz im Verfahrensschritt c) bestimmt sowie im anschliessenden Schritt d) in den Speicher Sp ausgegeben. Das Verfahren läuft in dieser Weise weiter mit Einführung der übrigen vorgegebenen Reaktanzwerte bis $X_{e3}$ mit Bildung und Ausgabe des letzten Wertes der Phasenwinkeldifferenz, beispielsweise also $d_3$. Es folgt ein neuer Zyklusdurchlauf, beginnend mit Aufnahme eines neuen Satzes der Messgrössen $d_m$, P, Q, $V_1$.

Zweckmässig wird ein seinen Inhalt zyklisch schrittweise erneuerter Speicher, ein sogenannter « rotierender » Speicher, verwendet, in dem jeweils die Verläufe der Grössen $d_m$ und $d_1$ bis $d_3$ über ein Zeitintervall T gespeichert ist. Die Erneuerung erfolgt in üblicher Weise durch Ueberschreiben des jeweils am längsten gespeicherten Wertesatzes durch den zuletzt aufgenommenen. Im Speicher stehen also immer geeignete Verlaufsabschnitte für die Aehnlichkeitsprüfung zur Verfügung.

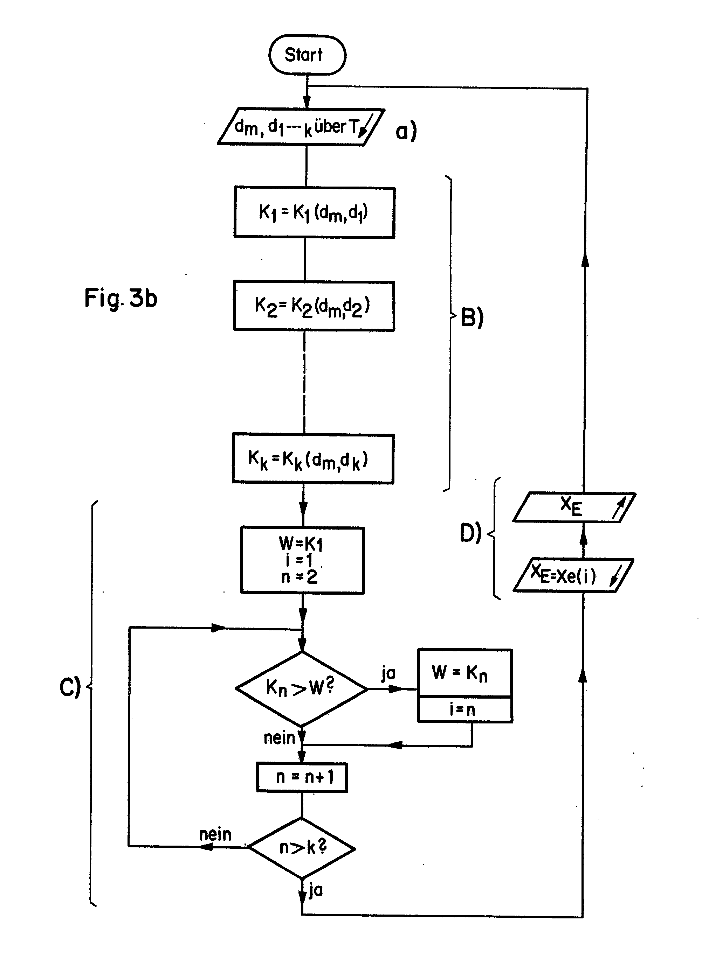

Die weitere Verarbeitung, wiederum im zyklischen Ablauf, ist in Fig. 3b veranschaulicht. Hier wird nach dem Start im Verfahrensschritt a) jeweils ein sich über das Intervall T erstreckender Wertesatz der Grössen $d_m$, $d_1$ bis $d_3$ aufgenommen und anschliessend im mehrschrittigen Verfahrensabschnitt B) der Aehnlichkeitsprüfung mit Bildung der Korrelate $K_1$ bis — allgemein — $K_k$ unterzogen. Sodann erfolgt im Verfahrensabschnitt C) unter Zuhilfenahme einer Anfangs gleich $K_1$ gesetzten Hilfsgrösse W sowie der Laufnummern i und n die Grenzwertauswahl der Aehnlichkeits-Kenngrössen, beispielsweise also die Maximalwertauswahl der gleichsinnig ähnlichkeitskennzeichnenden Korrelate $K_1$ bis $K_k$. Der hierzu verwendete Zyklus endet nach Prüfen aller Kenngrössen (n = k) mit Kennzeichnung der Laufnummer i des grössten Korrelats und Ausgabe des zugehörigen Reaktanzwertes $X_{e(i)}$ als Ergebnis. Das Verfahren kann anschliessend zyklisch weiterlaufen, so dass eine ständige Netzidentifikation für Regelungs- und Führungszwecke gegeben ist.

Bezeichnungsliste

| | |
|---|---|
| $x_m$ | Messort |
| G | Generator |
| $V_1$ | lokale Netzspannung |
| P | Wirkleistung |
| Q | Blindleistung |
| $G_P$ | Messeinrichtung |
| $G_Q$ | Messeinrichtung |
| $X_E$ | Ersatzreaktanz |
| F | Filter |
| $G_k$ | Korrelator |
| $K_{1...3}$ | Korrelate |
| T | Zeitintervall |
| $s_y$ | Synchron- bzw. Rückstellsignal |
| GG | Grenzwert-Auswahlschaltung |
| AL | Ausgabelogik |
| A | Ausgang |
| $d_{1...3}$ | Phasenwinkeldifferenzen |
| $d_m$ | lokaler Phasenwinkel |
| $X_{e1}-X_{e3}$ | Ersatzreaktanzwerte |
| t | Zeit |
| i | Laufnummer |
| $X_{e(i)}$ | Reaktanzwert |

**Ansprüche**

1. Verfahren zur Bestimmung einer Längs-Ersatzreaktanz in einem elektrischen Netz zwischen einem Messort ($x_m$) und einem Ort amplituden- und phasenstarrer Netzspannung ($V_2$), insbesondere am Anschlussort eines Generators an ein Leitungsnetz, gekennzeichnet durch folgende Merkmale :

a) am Messort ($x_m$) werden Messsignale für die Netzspannung ($V_1$), Wirkleistung (P) und Blindleistung (Q) sowie für den Phasenwinkel ($d_m$) der Netzspannung ($V_1$) gegenüber einer lokalen Referenz ($V_r$) gebildet ;

b) Es wird eine Mehrzahl von möglichen Werten ($X_{e1}$, $X_{e2}$, $X_{e3}$) der gesuchten Ersatzreaktanz vorgegeben und für jeden dieser Werte unter Zuhilfenahme der Messsignale für Netzspannung ($V_1$), Wirk- und Blindleistung (P bzw. Q) eine zugehörige Netzspannungs-Phasenwinkeldifferenz ($d_1-d_3$) zwischen den Netzspannungen ($V_1$, $V_2$) am Meßort ($x_m$) und dem Ort amplituden- und phasenstarrer Netzspannung bestimmt ;

c) der Zeitverlauf einer jeden Netzspannungs-Phasenwinkeldifferenz ($d_1-d_3$) wird mit demjenigen des Phasenwinkels ($d_m$) der Netzspannung ($V_1$) am Messort ($x_m$) verglichen und eine zugehörige Aehnlichkeits-Kenngrösse ($K_1-K_3$) gebildet ;

d) die Aehnlichkeits-Kenngrössen ($K_1-K_3$) werden einer Grenzwertauswahl im Sinne maximaler Uebereinstimmung des Zeitverlaufs der verglichenen Grössen ($d_m$ bzw. $d_1-d_3$) unterzogen, und der dem Grenzwert zugeordnete unter den vorgegebenen Ersatzreaktanzwerten ($X_{e1}$-$X_{e3}$) wird als Ergebnis ausgegeben.

2. Verfahren nach Anspruch 1, dadurch gekennzeichnet, dass der Zeitverlauf des Netzspannungs-Phasenwinkels ($d_m$) am Messort ($x_m$) und der Netzspannungs-Phasenwinkeldifferenzen ($d_1-d_3$) entsprechend den vorgegebenen Ersatzreaktanzwerten ($X_{e1}-X_{e3}$) abschnittsweise gespeichert und jeweils über einen solchen Abschnitt eine integrale Aehnlichkeitsprüfung zwischen den einzelnen Netzspannungs-Phasenwinkeldifferenzen ($d_1-d_3$) und dem Netzspannungs-Phasenwinkel ($d_m$) am Messort durchgeführt wird.

3. Verfahren nach Anspruch 2, dadurch gekennzeichnet, dass zur Aehnlichkeitsprüfung eine Differenzbildung zwischen dem Netzspannungs-Phasenwinkel ($d_m$) einerseits und je einer Netzspannungs-Phasenwinkeldifferenz ($d_1-d_3$) andererseits sowie eine integrale Korrelation mit einer der differenzbildenden Grössen ($d_m$ bzw. $d_1-d_3$) durchgeführt wird.

4. Verfahren nach Anspruch 2 oder 3, dadurch gekennzeichnet, dass eine laufende, schrittweise Erneuerung der jeweils gespeicherten Verlaufsabschnitte mit Speicherung jeweils eines aktuellen, neuen Wertes und Löschung des mit seiner Speicherung jeweils mit der längsten Zeitdauer zurückliegenden Speicherwertes durchgeführt wird.

5. Verfahren nach einem der vorangehenden Ansprüche, dadurch gekennzeichnet, dass der Zeitverlauf des Netzspannungs-Phasenwinkels ($d_m$) und/oder derjenige der Netzspannungs-Phasenwinkeldifferenzen ($d_1-d_3$) einer Filterung mit Unterdrückung von zeitlich linearen Komponenten, insbesondere einer Filterung mit Differentialkomponente, vorzugsweise mit Differential- und Integralkomponente, unterzogen wird.

6. Verfahren nach einem der vorangehenden Ansprüche, dadurch gekennzeichnet, dass zur Bestimmung des Phasenwinkels ($d_m$) einer Netzspannung ($V_1$) am Messort ($x_m$) eine Phasenwinkeldifferenz-Messeinrichtung (PM) mit einem wenigstens annähernd starren Oszillator (OS) als Referenzgeber verwendet wird.

7. Verfahren nach Anspruch 6, dadurch gekennzeichnet, dass der Phasenwinkeldifferenz-Messeinrichtung (PM) ein Filter (F) mit einer Differentialkomponente, vorzugsweise mit einer Differential- und Integralkomponente, zugeordnet ist.

**Claims**

1. A method for determining an equivalent direct-axis reactance in an electric network between a measuring point ($X_m$) and a point with amplitude- and phase-locked mains voltage ($V_2$), particularly at the point where a generator is connected to a network of lines, characterised by the following features :

a) at the measuring point ($x_m$) measuring signals are formed for the mains voltage ($V_1$), the active power (P) and the reactive power (Q) and for the phase angle ($d_m$) of the mains voltage ($V_1$) with respect to a local reference ($V_r$) ;

b) a plurality of possible values ($X_{e1}$, $X_{e2}$, $X_{e3}$) of the equivalent reactance required are preset and for each of these values an associated mains voltage phase angle difference ($d_1$-$d_3$) between the mains voltages ($V_1$, $V_2$) at the measuring point ($X_m$) and the point with amplitude- and phase-locked mains voltage is determined with the aid of the measured signals for the mains voltage ($V_1$), the active and the reactive power (P and Q, respectively) ;

c) the time-related characteristic of each mains voltage phase angle difference ($d_1$-$d_3$) is compared with that of the phase angle ($d_m$) of the mains voltage ($V_1$) at the measuring point ($x_m$) and an associated similarity parameter ($K_1$-$K_3$) is formed ;

d) the similarity parameters ($K_1$-$K_3$) are submitted to a limit-value selection process in the sense of maximum agreement in the time-related characteristic of the values compared ($d_m$ and $d_1$-$d_3$) and the value among the equivalent reactance values preset ($X_{e1}$-$X_{e3}$) which is associated with the limit value is output as the result.

2. A method according to claim 1, characterised in that the time-related characteristic of the mains voltage phase angle ($d_m$) at the measuring point ($x_m$) and of the mains voltage phase angle differences ($d_1$-$d_3$) is stored in sections corresponding to the equivalent reactance values ($X_{e1}$-$X_{e3}$) preset and that in each case an integral similarity check is carried out over such a section between the individual mains voltage phase angle differences ($d_1$-$d_3$) and the mains voltage phase angle ($d_m$) at the measuring point.

3. A method according to claim 2, characterised in that for the similarity check a difference is formed between the mains voltage phase angle ($d_m$) on the one hand and one mains voltage phase angle difference ($d_1$-$d_3$), on the other hand, and an integral correlation is carried out with one of the difference-forming values ($d_m$ and $d_1$-$d_3$, respectively).

4. A method according to claim 2 or 3, characterised in that the respective sections of characteristics stored are continuously refreshed step by step by storing in each case a current new value and deleting the stored value which in each case has been stored for the longest period of time.

5. A method according to one of the preceding claims, characterised in that the time-related characteristic of the mains voltage phase angle ($d_m$) and/or that of the mains voltage phase angle differences ($d_1$-$d_3$) are submitted to a filtering process involving the suppression of components which are linear in time, particularly a filtering process involving differential components and preferably involving differential and integral components.

6. A method according to one of the preceding claims, characterised in that for the determination of the phase angle ($d_m$) of a mains voltage ($V_1$) at the measuring point ($x_m$) a phase angle difference measuring device (PM) is used which has a reference source an oscillator (OS) which is a least approximately locked.

7. A method according to claim 6, characterised in that the phase angle difference measuring device (PM) is associated with a filter (F) involving a differential component and preferably involving a differential and integral component.

## Revendications

1. Procédé pour déterminer une réactance longitudinale de substitution dans un réseau électrique entre un endroit de mesure et un endroit à tension de réseau ($V_2$) de phase et d'amplitude fixes, en particulier à l'endroit de connexion d'un générateur au réseau de distribution, caractérisé en ce que :

a) à l'endroit de mesure ($x_m$), des signaux de mesure sont formés pour la tension de réseau ($V_1$), la puissance effective (P) et la puissance réactive (Q) ainsi que pour l'angle de phase ($d_m$) de la tension de réseau ($V_1$), par rapport à une référence locale ($V_r$) ;

b) plusieurs valeurs possibles ($X_{e1}$, $X_{e2}$, $X_{e3}$) de la réactance de substitution recherchée sont prédéfinies et pour chacune de ces valeurs, une différence d'angle de phase de tension de réseau ($d_1$-$d_3$) associée est déterminée avec l'aide des signaux de mesure pour la tension de réseau ($V_1$), la puissance effective et la puissance réactive (P ou Q), entre les tensions de réseau ($V_1$, $V_2$) à l'endroit de mesure ($X_m$) et l'endroit à tension de réseau d'amplitude et de phase fixes ;

c) la courbe de temps de chacune des différences d'angle de phase de tension de réseau ($d_1$-$d_3$) est comparée à celle de l'angle de phase ($d_m$) de la tension de réseau ($V_1$) à l'endroit de mesure ($X_m$) et une grandeur caractéristique de similitude ($K_1$-$K_3$) associée est formée ;

d) les grandeurs caractéristiques de similitude ($K_1$-$K_3$) sont soumises à une sélection de valeur de seuil dans le sens d'une coïncidence maximale de la courbe de temps des grandeurs comparées ($d_m$ ou $d_1$-$d_3$) et celle des valeurs de réactance de substitution ($X_{e1}$-$X_{e3}$) prédéfinies qui est associée à la valeur de seuil est fournie à titre de résultat.

2. Procédé suivant la revendication 1, caractérisé en ce que la courbe de temps de l'angle de phase de la tension de réseau ($d_m$) à l'endroit de mesure ($x_m$) et les différences d'angle de phase de tension de réseau ($d_1$-$d_3$) sont stockées section par section en fonction des valeurs de réactance de substitution prédéfinies ($X_{e1}$-$X_{e3}$) et un essai de similitude intégrale entre les différences d'angle de phase de tension de réseau individuelles ($d_1$-$d_3$) et l'angle de phase de tension de réseau ($d_m$) est effectué pour chaque section à l'endroit de mesure.

3. Procédé suivant la revendication 2, caractérisé en ce que pour effectuer l'essai de similitude, une différence est formée entre l'angle de phase de la tension de réseau ($d_m$) d'une part et chaque fois une différence d'angle de phase de tension de réseau ($d_1$-$d_3$) d'autre part et une corrélation intégrale est effectuée avec une des grandeurs formatrices de différence ($d_m$ ou $d_1$-$d_3$).

4. Procédé suivant la revendication 2 ou 3, caractérisé en ce qu'un renouvellement pas à pas continu des sections de courbes stockées est effectué par stockage chaque fois d'une nouvelle valeur réelle et par effacement de la valeur dont le stockage remonte le plus loin dans le temps.

5. Procédé suivant l'une quelconque des revendications précédentes, caractérisé en ce que la courbe de temps de l'angle de phase de tension de réseau ($d_m$) et/ou celles des différences d'angle de phase de la tension de réseau ($d_1$-$d_3$) sont soumises à un filtrage avec suppression de composantes linéaires dans le temps, en particulier un filtrage présentant des composantes différentielles, de préférence des composantes différentielles et intégrales.

6. Procédé suivant l'une quelconque des revendications précédentes, caractérisé en ce que pour déterminer l'angle de phase ($d_m$) d'une tension de réseau ($V_1$), à l'endroit de mesure ($x_m$), on utilise un dispositif de mesure de la différence d'angle de phase (PM) comportant un oscillateur au moins approximativement rigide (OS) à titre de générateur de référence.

7. Procédé suivant la revendication 6, caractérisé en ce qu'au dispositif de mesure de différence d'angle de phase (PM) est associé un filtre (F) présentant une composante différentielle, de préférence une composante différentielle et intégrale.

Fig.1

Fig. 2

Fig. 3a

Fig. 3b

$d_m, d_{1 \cdots k}$ über T    a)

$K_1 = K_1(d_m, d_1)$

$K_2 = K_2(d_m, d_2)$

$K_k = K_k(d_m, d_k)$

B)

$W = K_1$
$i = 1$
$n = 2$

$K_n > W?$    ja    $W = K_n$
                    $i = n$

nein

$n = n + 1$

nein    $n > k?$

ja

C)

$X_E$

$X_E = Xe(i)$

D)